# EUROPÄISCHE PATENTSCHRIFT

(11) **EP 0 550 850 B1**
(45) Veröffentlichungstag und Bekanntmachung des Hinweises auf die Patenterteilung: **03.09.1997**
(21) Anmeldenummer: 92121260.1
(22) Anmeldetag: 14.12.1992
(51) Int. Cl.: H01L 27/02, H01L 29/78, H01L 29/72

(54) **Monolithisch integrierbarer Temperatursensor für Leistungshalbleiterbauelemente und Verfahren zu dessen Herstellung**
Monolithically integratable temperature sensor for power semiconductor devices and method of making the same
Détecteur de température monolithiquement intégrable pour des dispositifs semi-conducteurs de puissance et procédé de fabrication associé

(30) Priorität: 08.01.1992 DE 4200291
(43) Veröffentlichungstag der Anmeldung: 14.07.1993
(73) Patentinhaber: SIEMENS AKTIENGESELLSCHAFT, 80333 München (DE)
(72) Erfinder: Hierold, Christofer, Dr., W-8000 München 70 (DE)

(56) Entgegenhaltungen:
- WO-A-89/08928
- DE-A- 4 107 909
- PATENT ABSTRACTS OF JAPAN vol. 13, no. 421 (E-822) 19. September 1989; & JP-A-11 57 573

## Beschreibung

Die Erfindung betrifft einen monolithisch integrierten Temperatursensor für Leistungshalbleiterbauelemente nach dem Oberbegriff des Patentanspruchs 1 und ein Verfahren zu dessen Herstellung.

Ein Temperatursensor, der zusammen mit einer vertikalen Leistungshalbleiterstruktur auf einem Halbleiterkörper monolithisch integriert ist, ist beispielsweise aus einem Beitrag zum Thema "TEMPFET: Schritt zum idealen Leistungshalbleiterschalter" in der Firmenschrift Siemens Components 27 (1989), Heft 6, Seite 228 bis 232, bekannt. Dabei handelt es sich um einen Temperatursensor der in Mehrchip- oder Hybridtechnik mit einem Leistungs-MOS-FET integriert ist.

Die internationale Anmeldung WO 89/08928 offenbart einen Temperatursensor der zusammen mit einer vertikalen Leistungshalbleiterstruktur auf einem Halbleiterkörper monolithisch integriert ist, wobei die Leistungshalbleiterstruktur einen Emitteranschluß, einen Kollektoranschluß und einen Gateanschluß aufweist und eine Vielzahl von Leistungszellen besitzt und wobei der Temperatursensor aus zwei Sensorzellen besteht, die gemeinsam mit der Vielzahl von Leistungszellen herstellbar sind.

Ferner ist aus den Patent Abstracts of Japan Vol. 13, No. 421 (E-822), 19.9.1989 bzw. aus der japanischen Anmeldeschrift JP-A-11 57 573 ein Temperatursensor nach dem Oberbegriff des Patentanspruchs 1 bekannt.

Aus der deutschen Offenlegungsschrift DE-A-41 07 909 ist ein IGBT als Leistungshalbleiterstruktur bekannt.

Der Erfindung liegt die Aufgabe zugrunde, einen monolithisch integrierbaren Temperatursensor und ein Verfahren zu dessen Herstellung anzugeben, bei dem der Temperatursensor eine hohe Empfindlichkeit besitzt und ohne zusätzliche Herstellungsschritte gemeinsam mit der Leistungshalbleiterstruktur des Leistungshalbleiterbauelementes prozeßkompatibel, einfach und platzsparend herstellbar ist.

Die genannte Aufgabe wird durch eine Anordnung und ein Verfahren zu dessen Herstellung gelöst, wobei die Anordnung durch die Merkmale des Patentanspruchs 1 und das Verfahren zu dessen Herstellung durch die Merkmale des Patentanspruchs 8 beschrieben sind.

Die Patentansprüche 2 bis 5 sind auf zweckmäßige Ausbildungen des erfindungsgemäßen Temperatursensors gerichtet.

Der mit der Erfindung erzielte Vorteil liegt insbesondere darin, daß der erfindungsgemäße Temperatursensor sowohl als temperaturabhängiger Schalter als auch als nahezu linearer Temperatur/Spannungs-Umsetzer beschaltbar ist.

Die Patentansprüche 6 und 7 beziehen sich auf eine vorteilhafte Verwendung des erfindungsgemäßen Temperatursensors.

Der Patentanspruch 9 ist auf eine bevorzugte Weiterbildung des Verfahrens zur Herstellung des erfindungsgemäßen Temperatursensors gerichtet.

Die Erfindung wird nachfolgend anhand der Zeichnung erläutert. Dabei zeigt
- Figur 1: eine Schnittdarstellung eines erfindungsgemäßen Temperatursensors zusammen mit einem Bereich einer vertikalen Leistungshalbleiterstruktur und
- Figur 2: ein Strom/Spannungs-Diagramm zur Erläuterung der Verwendungsmöglichkeiten des erfindungsgemäßen Temperatursensors.

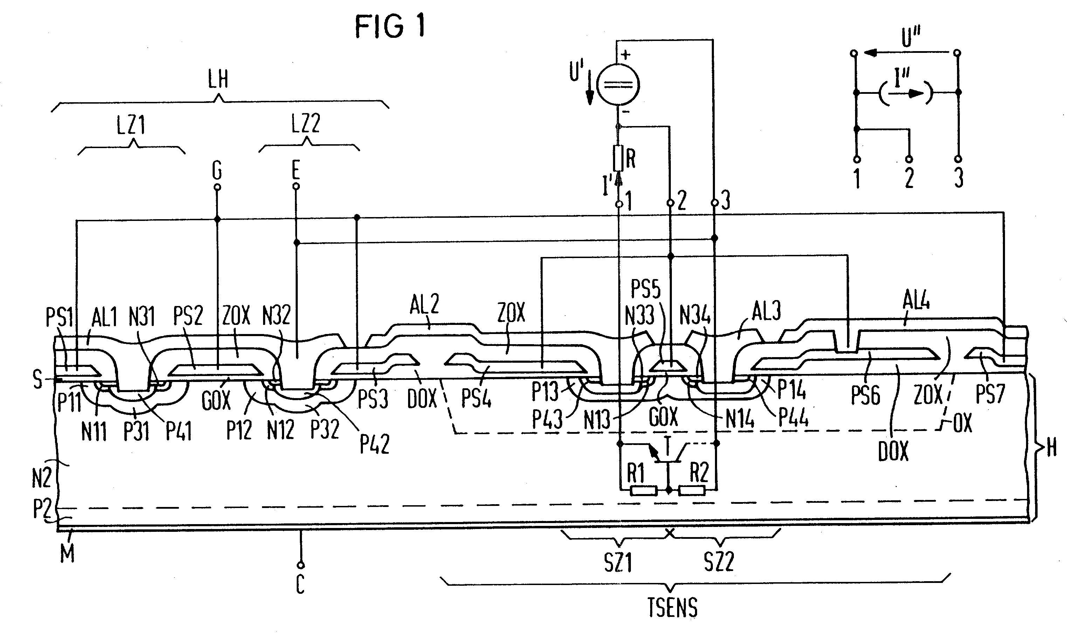

In Figur 1 ist ein Bereich eines Halbleiterkörpers H mit zwei Leistungszellen LZ1 und LZ2 einer Leistungshalbleiterstruktur LH und einem erfindungsgemäßen Temperatursensor TSENS aus zwei Sensorzellen SZ1 und SZ2 in einer Schnittdarstellung gezeigt. Die beiden Leistungszellen LZ1 und LZ2 stehen hierbei stellvertretend für eine Vielzahl von Leistungszellen und der Temperatursensor TSENS kann mehrmals auf dem Halbleiterkörper H vorgesehen sein. Der Halbleiterkörper H besteht hier im wesentlichen aus einem n-dotierten Substrat N2, in das p⁻-dotierte Wannen P11 und P12 von den Leistungszellen LZ1 und LZ2 und p⁻-dotierte Wannen P13 und P14 von den Sensorzellen SZ1 und SZ2 von einer Strukturierungsoberfläche S des Halbleiterkörpers H aus eingebracht sind. Die Leistungszelle LZ1 besitzt

innerhalb der Wanne P11 eine n⁺-dotierte Wanne N31 und die Leistungszelle LZ2 weist innerhalb der Wanne P12 eine n⁺-dotierte Wanne N32 auf. Entsprechend besitzt die Sensorzelle SZ1 innerhalb der Wanne P13 eine n⁺-dotierte Wanne N33 und die Sensorzelle SZ2 innerhalb der Wanne P14 eine n-dotierte Wanne N34. Die Wannen P11 und P12 der Leistungshalbleiterstruktur sind dabei durch das Substrat N2 voneinander getrennt. Beim Temperatursensor TSENS hingegen sind die Sensorzellen SZ1 und SZ2 so dicht angeordnet, daß die Wannen P13 und P14 ineinander übergehen und lediglich ein schmaler Bereich der Wannen P13 und P14 die beiden Wannen N33 und N34 in lateraler Richtung voneinander trennt. Zur Verbesserung der Eigenschaften der halbleiterstruktur ist zwischen der Wanne N31 und der Wanne P11 ein n⁻-dotierter Bereich N11 vorgesehen, der einen zwischen einer Kontaktierung AL1 und der Wanne P11 befindlichen p⁺⁺-dotierten Bereich P41 ringförmig umschließt. Unterhalb des Bereiches P41 besitzt die sonst p⁻-dotierte Wanne P11 einen p⁺-dotierten Bereich P31. Entsprechend ist zwischen der Wanne N32 und der Wanne P12 ein ringförmiger n⁻-dotierter Bereich N12 vorgesehen, der einen p⁺⁺-dotierten Bereich P42 zwischen der Kontaktierung AL1 und der Wanne P12 umschließt. Die sonst p⁻-dotierte Wanne P12 weist entsprechend unterhalb des Bereiches P42 einen p⁺-dotierten Bereich P32 auf. Die Sensorzellen können entsprechend wie die Leistungszellen ausgestaltet sein, wobei hier die Wannen P13 und P14 keine p⁺-dotierten Bereiche aufweisen. Von Vorteil ist jedoch wenn ein n⁻-dotierter Bereich N13 zwischen der Wanne N33 und der Wanne P13 nicht die Wanne N33 ringförmig umschließt, sondern nur in einem Bereich wo die Wannen P13 und P14 ineinander übergehen vorgesehen ist und sonst ein p⁺⁺-dotierter Bereich P43 zwischen einer Kontaktierung AL2 und der Wanne P13 vorhanden ist, wobei das Gebiet P43 bis zur Strukturierungsoberfläche S reicht und einen sogenannten "channel stop" zwischen der Wanne P13 und der Wanne N33 bildet. Entsprechendes gilt für einen n⁻-dotierten Bereich N14 zwischen der Wanne N34 und der Wanne P14 und einem p⁺⁺-dotierten Bereich zwischen einer Kontaktierung AL3 und der Wanne P 14. Oberhalb der Strukturierungsoberfläche S befinden sich im Bereich der Leistungshalbleiterstruktur LH durch ein Gateoxid GOX vom Halbleiterkörper H getrennt mindestens eine Gateelektrode PS1, PS2, PS3 und PS7 der Leistungshalbleiterstruktur, die als zusammenhängendes Gebiet oder in Form von mehreren Einzelelektroden ausgeführt sein kann. Im Bereich des Temperatursensors TSENS ist entsprechend mindestens eine Gateelektrode PS4, PS5 und PS6 des Temperatursensors vorgesehen, die ebenfalls entweder als zusammenhängendes Gebiet oder in Form von Einzelgebieten ausgebildet sein kann. Die Gateelektrode PS1, PS2, PS3 und PS7 der Leistungshalbleiterstruktur ist mit einem Gateanschluß G verbunden und die Kontaktierung AL1 mit einem Emitteranschluß E des Leistungshalbleiterbauelements angeschlossen. Die Kontaktierung AL1 bildet mit der Kontaktierung AL3 ein zusammenhängendes Gebiet, wodurch eine Verbindung zwischen einem Sensoranschluß 3 und dem Emitteranschluß E des Leistungshalbleiterbauelementes besteht, die Kontaktierungen AL1 und AL4 hingegen sind davon und untereinander durch Oxidschichten isoliert. Beim Temperatursensor ist die Kontaktierung AL2 mit einem Sensoranschluß 1, die Kontaktierung AL3 mit dem Sensoranschluß 3 und die Gateelektrode PS4, PS5 und PS6 des Temperatursensors beispielsweise über die Kontaktierung AL4 mit einem Sensoranschluß 2 verbunden, wodurch eine Vorspannung anlegbar ist. Zwischen den Kontaktierungen AL1 ... AL4 und den Gateelektroden PS1 ... PS7 befindet sich ein Zwischenoxid ZOX und an den lateralen Grenzen zwischen der stungshalbleiterstruktur und dem Temperatursensor ist das Gateoxid GOX zu einem Dickoxid DOX verdickt. Auf der der Strukturierungsoberfläche S abgewandten Oberfläche des Halbleiterkörpers H befindet sich eine Metallisierungsschicht M, die mit einem Kollektoranschluß C des Leistungshalbleiterbauelementes verbunden ist und beispielsweise aus AlTiNiAg besteht.

Alternativ zu der in Figur 1 dargestellten Anordnung ist eine Anordnung denkbar, bei der sowohl die Gateelektrode PS1 ... PS3 und PS7 der Leistungshalbleiterstruktur als auch die Gateelektrode PS4 ... PS6 des Temperatursensors mit dem Gateanschluß G des Leistungshalbleiterbauelementes durch eine zusammenhängende Schicht, beispielsweise Poly-Silizium-Schicht, verbunden sind, bei der das Dickoxid DOX nicht vorgesehen ist und bei der der Sensoranschluß 2 unbeschaltet ist. Ein Temperatursensor dieser Anordnung kann jedoch nur während der Schaltpausen, also wenn die Spannung zwischen Gateanschluß G und dem Emitteranschluß E ca. 0 Volt beträgt, betrieben werden, da er sonst einen Teil des Laststroms führt.

Eine Isolation des Temperatursensors TENS vom Substrat N2 kann durch eine Raumladungszone oder durch eine in Figur 1 gestrichelt angedeutete Oxidschicht OX bewirkt werden. Die Raumladungszone ist durch eine geeignete Spannung zwischen den Wannen P13 und P14 und dem Substrat N2 erzeugbar. Sind, wie in Figur 1 gezeigt, die Wannen p-leitend und das Substrat n-leitend, so muß die Sensorzelle S21 gegenüber dem Emitteranschluß E hierzu negativ vorgespannt sein.

Handelt es sich beispielsweise beim Leistungshalbleiterbauelement um einen Leistungs-MOS-FET, so grenzt das n-dotierte Substrat N2 direkt an die Metallisierungsschicht M, handelt es sich jedoch beim Leistungshalbleiterbauelement um einen IGBT (isolated gate bipolartransistor), so ist zwischen dem n-dotierten Substrat N2 und der Metallisierungsschicht M eine in Figur 1 gestrichelt angedeutete p-dotierte Schicht P2 vorgesehen, wobei bei einem sogenannten "punch through IGBT" zwischen dem Substrat N2 und der Schicht P2 eine n⁺-dotierte Pufferschicht zusätzlich vorhanden ist.

Der Halbleiterkörper H hat dabei beispielsweise eine vertikale Dicke von ca. 200 bis 300 µm und die p⁻-dotierten Wannen P11 ... P14 weisen beispielsweise eine vertikale Tiefe von ca. 6 µm auf. Die Dotierungskonzentration des n-dotierten Substrats beträgt beispielsweise 5 ∗ 10¹³ cm⁻³, die der n⁻-dotierten Gebiete 10¹⁷ bis 10¹⁸ cm⁻³ und die der n⁺-dotierten Gebiete 10²⁰ cm⁻³, wobei die Dotierung beispielsweise mit Phosphor erfolgt. Die Dotierungskonzentration für die p⁻-dotierten Gebiete beträgt beispielsweise 10¹⁷ cm⁻³ die der p-dotierten Gebiete 10¹⁶ cm⁻³, die der p⁺-dotierten Gebiete 10¹⁸ cm⁻³ und die der p⁺⁺-dotierten Gebiete 10¹⁹ cm⁻³, wobei beispielsweise eine Dotierung mit Bor erfolgt.

Ferner ist in Figur 1 ein näherungsweise gültiges Ersatzschaltbild mit einem Bipolartransistor T und Wannenwiderständen R1 und R2 dargestellt, wobei der Emitteranschluß des Transistors T mit dem Sensoranschluß 1, der Kollektoranschluß des Transistors T mit dem Sensoranschluß 3 und der Basisanschluß des Transistors T über den Wannenwiderstand R1 mit dem Sensoranschluß 1 und über den Wannenwiderstand R2 mit dem Sensoranschluß 3 verbunden ist. Wird die Abtrennelektrode PS4, PS5 und PS6 als Implantationsmaske benützt, so sind die beiden stark dotierten Wannen N33 und N34 in der Regel so weit von einander entfernt, daß kein Transistoreffekt entsteht, sondern nur die Basis-Emitterdiode des Transistors T zusammen mit den Wannenwiderständen R1 und R2 wirksam ist.

Da die Basis-Emitterdiode über einen Spannungsteiler aus den Wannenwiderständen R1 und R2 angesteuert wird, ist nur dessen Teilerverhältnis nicht die Absolutwerte der Wannenwiderstände für den Einsatzpunkt der Basis-Emitter-Diode relevant und der Einfluß des Herstellungsprozesses auf die Sensoreigenschaften gering und damit die Reproduzierbarkeit hoch.

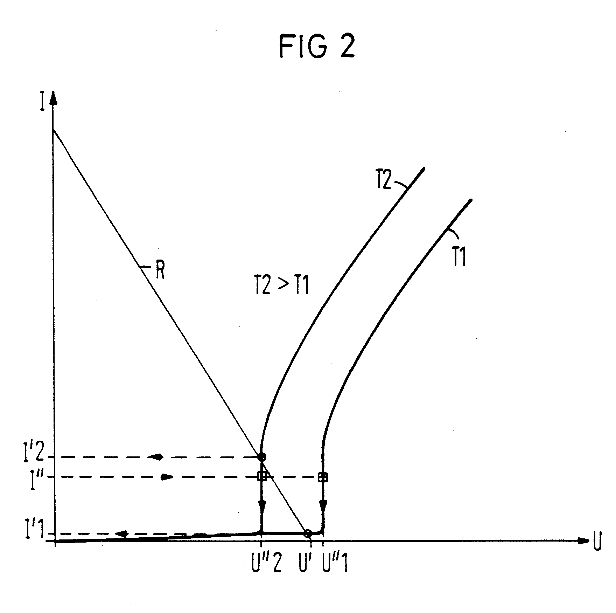

In Figur 2 sind zur Erläuterung der Verwendungsmöglichkeiten des erfindungsgemäßen Temperatursensors in einem Strom/Spannungs-Diagramm zwei Kennlinien des erfindungsgemäßen Sensors in Abhängigkeit der Temperaturwerte T1 und T2 dargestellt. Aufgrund der monolithischen Integration von Leistungshalbleiterstruktur und Temperatursensor entspricht die Sensortemperatur weitgehend der Temperatur der Leistungshalbleiterstruktur. Wird beispielsweise, wie in Figur 1 dargestellt, eine Spannungsquelle mit einer Spannung U', die typischer Weise zwischen 0 und 15 V liegt, über einen Begrenzungswiderstand R mit den Anschlüssen 1 und 3 des Sensors verbunden, so kann der erfindungsgemäße Temperatursensor erfindungsgemäß als Temperaturschalter Verwendung finden. Aus Figur 2 wird dies dadurch deutlich, daß sich durch den Schnittpunkt der Widerstandsgeraden für den Begrenzungswiderstand R und der Kennlinie für die niedrigere Temperatur T1 ein sehr geringer Strom I'1 und aus dem Schnittpunkt der Widerstandsgeraden mit der Kennlinie für die höhere Temperatur T2 ein wesentlich höherer Strom I'2 durch den Temperatursensor ergibt. Die Spannungsquelle mit der Spannung U' kann ferner dazu benutzt werden die Gateelektroden PS4 ... PS6 des Temperatursensors gegenüber dem Emitteranschluß E die Leistungshalbleiterstruktur LH in geeigneter Weise vorzuspannen, um einen leitenden Kanal zwischen den Wannen N33 und N34 oder, falls vorhanden, zwischen den Bereichen N13 und N14 zu verhindern.

In Figur 1 ist alternativ eine weitere erfindungsgemäße Beschaltung des erfindungsgemäßen Temperatursensors gezeigt. Dabei ist eine Stromquelle, die einen Konstantstrom I'' in den Sensor einprägt, mit den Anschlüssen 1 und 3 verbunden und es entsteht eine temperaturabhängige Spannung U'' zwischen den Sensoranschlüssen 1 und 3. Hierbei kann der erfindungsgemäße Temperatursensor als nahezu linearer Temperatur/Spannungs-Umsetzer verwendet werden und es ergibt sich beispielsweise bei einer Spannung von U'' = 6 Volt eine Temperaturempfindlichkeit von ca. -20 mV/K. Der Sensoranschluß 2 ist dabei so mit einem der beiden Anschlüsse 1 oder 3 zu verbinden, daß sich eine geeignete Vorspannung für die Gateelektrode des Temperatursensors ergibt. In Figur 2 ist der eingeprägte Konstantstrom I'' eingezeichnet und bewirkt zusammen mit der Kennlinie für die niedrigere Temperatur T1 eine Spannung U''1 und im Zusammenhang mit der Kennlinie für die höhere Temperatur T2 eine Spannung U''2, die kleiner als die Spannung U1 ist.

Beim erfindungsgemäßen Verfahren zur Herstellung eines erfindungsgemäßen Temperatursensors wird beispielsweise auf der Strukturierungsoberfläche S des Halbleiterkörpers H die Gateoxidschicht GOX und die Dickoxidschicht DOX aufgewachsen, wobei das Dickoxid beispielsweise ringförmig um einen Bereich für den späteren Temperatursensor gebildet wird. Nun wird beispielsweise ganzflächig über das Gateoxid GOX und das Dickoxid DOX, zur gleichzeitigen Bildung der Gateelektrode PS1, PS2, PS3 und PS7 der Leistungshalbleiterstruktur und der Gateelektrode PS4, PS5 und PS6 des Temperatursensors, beispielsweise eine Polysiliziumschicht ganzflächig aufgebracht und mit einer Lackmaske bedeckt. Bei einem folgenden Ätzvorgang wird die Polysiliziumschicht im Bereich der Leistungszellen LZ1 und LZ2 im Bereich der Sensorzellen SZ1 und SZ2 sowie oberhalb des ringförmigen Dickoxids DOX entfernt, so daß die Gateelektrode stungshalbleiterstruktur von der Gateelektrode des Temperatursensors getrennt ist. Beide Gateelektroden werden nun vorteilhafterweise zur selbstjustierenden Implantation einer Dotierung zur Bildung der schwach dotierten Wannen P11 ... P14 verwendet. Nach einem sich anschließenden Tempervorgang besitzen die Wannen P11 ... P14 eine größere Ausdehnung und reichen unter die beiden Gateelektroden, wobei die beiden schwach dotierten Wannen P13 und P14 der Sensorzellen SZ1 und SZ2 ineinander übergehen und eine gemeinsame schwach dotierte Wanne bilden. Die Gateelektrode der Leistungshalbleiterstruktur und die Gateelektrode des Temperatursensors können nun auch für eine selbstjustierende Implantation der stark dotierten Wannen N31 ... N34 benützt werden. Zur Verbesserung der Leistungshalbleiterstruktur kann vor dem Einbringen der hochdotierten Wannen N31 ... N34 selbstjustierend ein Einbringen der n⁻-dotierten Bereiche N11 ... N14 erfolgen. Zur weiteren Verbesserung der Leistungshalbleiterstruktur kann vor der Bildung der Gateelektroden PS1 ... PS7 ein Erzeugen der p⁺-dotierten Bereiche P31 und P32 bei den Leistungszellen sowie der p⁺-dotierten Bereiche P41 ... P44 mit Hilfe einer Implantationsmaske erfolgen, wobei die Bereiche N13 und N14 vorteilhafter Weise nur zwischen den Sensorzellen und die Bereiche P43 und P44 ringförmig um die beiden Sensorzellen SZ1 und SZ2 und bis zur turierungsoberfläche S reichend ausgebildet werden können. Sind alle Dotierungen des Halbleiterkörpers H erfolgt, wird der mit Oxidschichten und Elektroden versehene Halbleiterkörper ganzflächig mit einer Zwischenoxidschicht (ZOX) abgedeckt, in die dann anschließend im Bereich einer jeweiligen Leistungszelle und im Bereich einer jeweiligen Sensorzelle sowie im Anschlußbereich für die Gateelektroden gleichzeitig ein Kontaktloch geätzt wird. Anschließend werden die, beispielsweise aus Aluminium bestehenden, Kontaktierungen AL1 ... AL4 für die Leistungszellen und die Sensorzellen gemeinsam erzeugt. Falls der Temperatursensor TSENS galvanisch von der Leistungshalbleiterstruktur LH getrennt werden soll, so kann im Bereich des späteren Temperatursensors eine dicke Oxidschicht aufgewachsen werden und ein inselförmiger Bereich des dicken Oxids zu Silizium rückgebildet werden, um den Temperatursensor TSENS durch eine Oxidschicht OX vom Leistungshalbleiter LH zu isolieren.

Da ein zur Bildung des p⁻-dotierten Bereiches zwischen den beiden stark dotierten Wannen N33 und N34 vorgesehener Teil der Abtrennelektrode PS5 nicht beliebig schmal, sondern aus technologischen Gründen beispielsweise einige µm sein muß, kann der Teil PS5 der Gateelektrode des Temperatursensors vorerst weggelassen werden und die Wannen P13 und P14 als ein Bereich implantiert werden. Zur Erzeugung sehr dicht nebeneinander liegender stark dotierten Wannen N33 und N34 und einem entsprechend schmalen Teil PS5 der Gateelektrode müßten dann allerdings zusätzliche Herstellungsschritte vorgesehen werden.

## Patentansprüche

1. Anordnung mit einem Temperatursensor (TSENS), der zusammen mit einer vertikalen Leistungshalbleiterstruktur (LH) auf einem Halbleiterkörper (H) monolithisch integriert ist,
bei dem die Leistungshalbleiterstruktur einen Emitteranschluß (E), einen Kollektoranschluß (C) und einen Gateanschluß (G) aufweist und eine Vielzahl von Leistungszellen (LZ1, LZ2 ...) besitzt,
bei dem der Temperatursensor aus zwei Sensorzellen (SZ1, SZ2) besteht, die gemeinsam mit der Vielzahl von Leistungszellen (LZ1, LZ2 ...) herstellbar sind,
bei dem sowohl die zwei Sensorzellen als auch die Vielzahl von Leistungszellen jeweils eine niedrig dotierte Wanne (P11 ... P14) eines ersten Leitungstyps besitzen und die jeweilige niedrig dotierte Wanne (P11 ... P14) mindestens eine stark dotierte Wanne (N31 ... N34) des zweiten Leitungstyps beinhaltet,
bei dem die zwei Sensorzellen und die Vielzahl von Leistungszellen in ein gemeinsames Substrat (N2) des zweiten Leitungstyps eingebracht sind,
bei dem die zwei Sensorzellen (SZ1, SZ2) so dicht nebeneinander liegen, daß die niedrig dotierten Wannen (P13, P14) der beiden Sensorzellen ineinander übergehen und nur ein schmaler niedrig dotierter Bereich des ersten Leitungstyps zwischen den beiden stark dotierten Wannen des zweiten Leitungstyps bestehen bleibt, der die Basis eines aus den stark dotierten Wannen und dem niedrig dotierten Bereich bestehenden parasitären Bipolartransistor (T) bildet,
**dadurch gekennzeichnet**,
daß ein erster Sensoranschluß (1) über einen ersten Widerstand (R1) und ein zweiter Sensoranschluß (3) über einen zweiten Widerstand (R2) mit der Basis des parasitären Bipolartransistors (T) verbunden sind und das Potential der Basis durch das Teilerverhältnis aus den beiden Widerständen festgelegt ist,
daß der erste Widerstand (R1) durch die (P13) niedrig dotierte Wanne des ersten Leitungstyps einen ersten Sensorzelle (SZ1) gebildet wird, daß eine Kontaktierung (AL2) der ersten Sensorzelle (SZ1), welche mit dem ersten Sensoranschluß und der stark dotierten Wanne der ersten Sensorzelle verbunden ist, sowohl über ein Gebiet (P43) des ersten Leitungstyps als auch über ein oder mehrere Gebiete (N33, N13) eines zweiten Leitungstyps mit dem ersten Widerstand verbunden ist, und
daß der zweite Widerstand (R2) durch die niedrig dotierte Wanne (P14) des ersten Leitungstyps der zweiten Sensorzelle (SZ2) gebildet wird, und
daß eine Kontaktierung (AL3) der zweiten Sensorzelle (SZ2), welche mit dem zweiten Sensoranschluß und der starck dotierten Wanne der zweiten Sensorzelle verbunden ist, sowohl über ein Gebiet (P44) des ersten Leitungstyps als auch über ein oder mehrere Gebiete (N34, N14) eines zweiten Leitungstyps mit dem zweiten Widerstand verbunden ist.

2. Anordnung (TENS) nach Anspruch 1,
**dadurch gekennzeichnet,**
daß der Temperatursensor von der Leistungshalbleiterstruktur (LH) durch einen in Sperrichtung gepolten pn-Übergang zwischen den den ersten und zweiten Widerstand bildenden niedrig dotierten Wannen (P13, P14) des ersten Leitungstyps und dem gemeinsamen Substrat (N2) getrennt ist.

3. Anordnung nach Anspruch 1,
**dadurch gekennzeichnet,**
daß der Temperatursensor durch eine Oxidschicht (OX) von der Leistungshalbleiterstruktur (LH) elektrisch isoliert ist.

4. Anordnung nach einem der Ansprüche 1 bis 3,
**dadurch gekennzeichnet,**
daß der Temperatursensor mit einem vertikalen Leistungs-MOS-FET monolithisch integriert ist.

5. Anordnung nach einem der Ansprüche 1 bis 3,
**dadurch gekennzeichnet,**
daß der Temperatursensor mit einem IGBT monolithisch integriert ist.

6. Verwendung einer Anordnung nach einem der Ansprüche 1 bis 5,
**gekennzeichnet dadurch,**
daß der Temperatursensor als temperaturabhängiger Schalter verwendet wird, wobei eine Reihenschaltung aus einer Spannungsquelle (U') und einem Begrenzungswiderstand (R) mit dem ersten und zweiten Sensoranschluß (1, 3) verbunden ist.

7. Verwendung einer Anordnung nach einem der Ansprüche 1 bis 5,
**gekennzeichnet dadurch,**
daß der Temperatursensor als weitgehend linearer Temperatur/Spannungs-Umsetzer verwendet wird, wobei eine Stromquelle direkt mit dem ersten und zweiten Sensoranschluß (1, 3) verbunden ist und ein eingeprägter Konstantstrom (I") zwischen den Sensoranschlüssen eine temperaturabhängige Ausgangsspannung (U'') bewirkt.

8. Verfahren zur Herstellung einer Anordnung nach Anspruch 1,
welches folgende Schritte beinhaltet:
gleichzeitiges Abdecken eines Bereiches für die Vielzahl von Leistungszellen (LZ1, LZ2 ...) und eines Bereiches für die zwei Sensorzellen (SZ1, SZ2) mit wenigstens einer Oxidschicht (GOX, DOX);
gleichzeitiges Erzeugen von schwach dotierten Wannen (P11, P12) des ersten Leitungstyps für die Vielzahl von Leistungszellen (LZ1, LZ2 ...) der Leistungshalbleiterstruktur (LH) zusammen mit schwach dotierten Wannen (P13, P14) des ersten Leistungstyps für die zwei Sensorzellen (SZ1, SZ2), wobei die beiden schwach dotierten Wannen (P13, P14) für die Sensorzellen (SZ1, SZ2) so dicht nebeneinander liegen, daß sie beim Erzeugen ineinander übergehen;
gleichzeitiges Erzeugen von stark dotierten Wannen (N31, N32) des zweiten Leitungstyps für die Vielzahl der Leistungszellen der Leistungshalbleiterstruktur zusammen mit stark dotierten Wannen (N33, N34) des zweiten Leitungstyps für die zwei Sensorzellen, wobei sich die beiden stark dotierten Wannen (N33, N34) für die Sensorzellen innerhalb der schwach dotierten Wannen für die Sensorzellen befinden und so dicht nebeneinander liegen, daß nur ein schmaler niedrig dotierter Bereich des ersten Leitungstyps bestehen bleibt;
gleichzeitiges Bilden einer Zwischenoxidschicht (ZOX) mit Kontaktlöchern für die Vielzahl von Leistungszellen und einer Zwischenoxidschicht (ZOX) mit Kontaktlöchern für die beiden Sensorzellen;
und gleichzeitiges Anbringen von Kontaktierungen (AL2 ... AL4) für die Sensorzellen (SZ1, SZ2) und von Kontaktierungen (AL1) für die Vielzahl der Leistungszellen (LZ1, LZ2 ...).

9. Verfahren nach Anspruch 8,
**dadurch gekennzeichnet,**
daß gleichzeitig mindestens eine durch wenigstens eine Oxidschicht (GOX, DOX) vom Halbleiterkörper getrennte Gateelektrode (PS1 ... PS3) der Leistungshalbleiterstruktur für die Vielzahl von Leistungszellen und mindestens eine durch wenigstens eine Oxidschicht (GOX, DOX) vom Halbleiterkörper getrennte Gateelektrode (PS4 ... PS6) des Temperatursensors für die beiden Sensorzellen vorgesehen werden und die beiden Gateelektroden als Maske dienen, um sowohl die schwach dotierten Wannen (P11 ... P14) des ersten Leitungstyps als auch die stark dotierten Wannen (N31 ... N34) des zweiten Leitungstyps selbstjustierend zu erzeugen, wobei die Abmessungen der schwach dotierten Wannen gegenüber den Abmessungen der stark dotierten Wannen dadurch vergrößert werden, daß nach dem Einbringen der Dotierung für die schwach dotierten Wannen ein Tempervorgang erfolgt.

## Claims

1. Arrangement having a temperature sensor (TSENS) which is monolithically integrated together with a vertical power semiconductor structure (LH) on a semiconductor body (H),
in which the power semiconductor structure has an emitter terminal (E), a collector terminal (C) and a gate terminal (G) and has a multiplicity of power cells (LZ1, LZ2 ...),
in which the temperature sensor comprises two sensor cells (SZ1, SZ2) which can be produced jointly with the multiplicity of power cells (LZ1, LZ2 ...),
in which both the two sensor cells and the multiplicity of power cells each have a weakly doped well (P11 ... P14) of a first conduction type and the respective weakly doped well (P11 ... P14) contains at least one heavily doped well (N31 ... N34) of the second conduction type, in which the two sensor cells and the multiplicity of power cells are introduced into a common substrate (N2) of the second conduction type,
in which the two sensor cells (SZ1, SZ2) are situated next to one another in close proximity such that the weakly doped wells (P13, P14) of the two sensor cells merge into one another and only a narrow, weakly doped region of the first conduction type remains between the two heavily doped wells of the second conduction type and forms the base of a parasitic bipolar transistor (T) comprising the heavily doped wells and the weakly doped region,
characterized
in that a first sensor terminal (1) is connected to the base of the parasitic bipolar transistor (T) via a first resistor (R1) and a second sensor terminal (3) is connected to the base of the parasitic bipolar transistor (T) via a second resistor (R2), and the potential of the base is defined by the divider ratio of the two resistors,
in that the first resistor (R1) is formed by the weakly doped well (P13) of a first conduction type of a first sensor cell (SZ1),
in that a contact-making layer (AL2) of the first sensor cell (SZ1), which is connected to the first sensor terminal and the heavily doped well of the first sensor cell, is connected to the first resistor both via a region (P43) of the first conduction type and via one or more regions (N33, N13) of a second conduction type, and in that the second resistor (R2) is formed by the weakly doped well (P14) of a first conduction type of the second sensor cell (SZ2), and
in that a contact-making layer (AL3) of the second sensor cell (SZ2), which is connected to the second sensor terminal and the heavily doped well of the second sensor cell, is connected to the second resistor both via a region (P44) of the first conduction type and via one or more regions (N34, N14) of a second conduction type.

2. Arrangement (TSENS) according to Claim 1, characterized in that the temperature sensor is isolated from the power semiconductor structure (LH) by a reverse-biased pn junction between the weakly doped wells (P13, P14) of the first conduction type which form the first and second resistors and the common substrate (N2).

3. Arrangement according to Claim 1, characterized in that the temperature sensor is electrically insulated from the power semiconductor structure (LH) by means of an oxide layer (OX).

4. Arrangement according to one of Claims 1 to 3, characterized in that the temperature sensor is monolithically integrated with a vertical power MOSFET.

5. Arrangement according to one of Claims 1 to 3, characterized in that the temperature sensor is monolithically integrated with an IGBT.

6. Use of an arrangement according to one of Claims 1 to 5, characterized in that the temperature sensor is used as a temperature-dependent switch, a series circuit formed by a voltage source (U') and a limiting resistor (R) being connected to the first and second sensor terminals (1, 3).

7. Use of an arrangement according to one of Claims 1 to 5, characterized in that the temperature sensor is used as a largely linear temperature/voltage converter, a current source being connected directly to the first and second sensor terminals (1, 3), and an impressed constant current (I") effecting a temperature-dependent output voltage (U") between the sensor terminals.

8. Method for producing an arrangement according to Claim 1, which comprises the following steps:
simultaneous covering of a region for the multiplicity of power cells (LZ1, LZ2 ...) and of a region for the two sensor cells (SZ1, SZ2) with at least one oxide layer (GOX, DOX);
simultaneous production of weakly doped wells (P11, P12) of the first conduction type for the multiplicity of power cells (LZ1, LZ2 ...) of the power semiconductor structure (LH) together with weakly doped wells (P13, P14) of the first conduction type for the two sensor cells (SZ1, SZ2), the two weakly doped wells (P13, P14) for the sensor cells (SZ1, SZ2) being situated next to one another in close proximity such that they merge into one another during production;
simultaneous production of heavily doped wells (N31, N32) of the second conduction type for the multiplicity of power cells of the power semiconductor structure together with heavily doped wells (N33, N34) of the second conduction type for the two sensor cells, the two heavily doped wells (N33, N34) for the sensor cells being situated within the weakly doped wells for the sensor cells and being situated next to one another in close proximity such that only a narrow, weakly doped region of the first conduction type remains;
simultaneous formation of an intermediate oxide layer (ZOX) with contact holes for the multiplicity of power cells and of an intermediate oxide layer (ZOX) with contact holes for the two sensor cells;
and simultaneous application of contact-making layers (AL2 ... AL4) for the sensor cells (SZ1, SZ2) and of contact-making layers (AL1) for the multiplicity of power cells (LZ1, LZ2 ...).

9. Method according to Claim 8, characterized in that provision is simultaneously made of at least one gate electrode (PS1 ... PS3), which is isolated from the semiconductor body by at least one oxide layer (GOX, DOX), of the power semiconductor structure for the multiplicity of power cells, and of at least one gate electrode (PS4 ... PS6), which is isolated from the semiconductor body by at least one oxide layer (GOX, DOX), of the temperature sensor for the two sensor cells, and the two gate electrodes serve as a mask in order to produce both the weakly doped wells (P11 ... P14) of the first conduction type and the heavily doped wells (N31 ... N34) of the second conduction type in a self-aligning manner, the dimensions of the weakly doped wells being enlarged in comparison with the dimensions of the heavily doped wells by effecting a heat-treatment operation after the introduction of the doping for the weakly doped wells.

## Revendications

1. Dispositif comportant un détecteur de température (TSENS) qui est intégré monolithiquement, ensemble avec une structure à semi-conducteurs de puissance (LH) verticale, dans un corps à semi-conducteurs (H),
- dans lequel la structure à semi-conducteurs de puissance comporte une borne d'émetteur (E), une borne de collecteur (C) et une borne de grille (G) et possède une pluralité de cellules de puissance (LZ1, LZ2 ...),
- dans lequel le détecteur de température est composé de deux cellules de détecteur (SZ1, SZ2) pouvant être réalisées ensemble avec la pluralité de cellules de puissance (LZ1, LZ2 ...),
- dans lequel les deux cellules de détecteur ainsi que la pluralité de cellules de puissance possèdent chacune une cuve (P11 . . . P14) faiblement dopée d'un premier type de conductivité, chaque cuve (P11 . . . P14) faiblement dopée comportant au moins une cuve (N31 . . . N34) fortement dopée du second type de conductivité,
- dans lequel les deux cellules de détecteur et la pluralité de cellules de puissance sont intégrées dans un substrat (N2) commun du second type de conductivité,
- dans lequel les deux cellules de détecteur (SZ1, SZ2) sont si proches l'une de l'autre que les cuves (P13, P14) faiblement dopées des deux cellules de détecteur se fondent l'une dans l'autre et ne laissent subsister entre les deux cuves fortement dopées du second type de conductivité qu'une zone étroite faiblement dopée du premier type de conductivité, qui constitue la base d'un transistor bipolaire (T) parasitaire composé des cuves fortement dopées et de la zone faiblement dopée,
caractérisé en ce que
- une première borne de détecteur (1) et une seconde borne de détecteur (3) sont reliées, respectivement par l'intermédiaire d'une première résistance (R1) et d'une seconde résistance (R2), à la base du transistor bipolaire (T) parasitaire et en ce que le potentiel de la base est défini par le rapport de division entre les deux résistances,
- la première résistance (R1) est réalisée par la cuve (P13) faiblement dopée du premier type de conductivité d'une première cellule de détecteur (SZ1),
- une liaison (AL2) de la première cellule de détecteur (SZ1), laquelle est reliée à la première borne de détecteur et à la cuve fortement dopée de la première cellule de détecteur, est reliée, par l'intermédiaire d'une zone (P43) du premier type de conductivité ainsi que par l'intermédiaire d'une ou plusieurs zones (N33, N13) d'un second type de conductivité, à la première résistance, et
- la seconde résistance (R2) est réalisée par la cuve (P14) faiblement dopée du premier type de conductivité de la seconde cellule de détecteur (SZ2), et
- une liaison (AL3) de la seconde cellule de détecteur (SZ2), laquelle est reliée à la seconde borne de détecteur et à la cuve fortement dopée de la seconde cellule de détecteur, est reliée, par l'intermédiaire d'une zone (P44) du premier type de conductivité ainsi que par l'intermédiaire d'une ou plusieurs zones (N34, N14) d'un second type de conductivité, à la seconde résistance.

2. Dispositif selon la revendication 1, caractérisé en ce que le détecteur de température est séparé de la structure à semi-conducteurs de puissance (LH) par une jonction p-n polarisée dans le sens de blocage située entre les cuves (P13, P14) faiblement dopées du premier type de conductivité, qui forment la première et la seconde résistance, et le substrat (N2) commun.

3. Dispositif selon la revendication 1, caractérisé en ce que le détecteur de température est isolé électriquement contre la structure à semi-conducteurs de puissance (LH) par une couche d'oxyde (OX).

4. Dispositif selon l'une des revendications 1 à 3, caractérisé en ce que le détecteur de température est intégré monolithiquement avec un MOSFET de puissance.

5. Dispositif selon l'une des revendications 1 à 3, caractérisé en ce que le détecteur de température est intégré monolithiquement avec un IGBT.

6. Utilisation d'un dispositif selon l'une des revendications 1 à 5, caractérisée en ce que le détecteur de température est utilisé comme commutateur dépendant de la température, un montage en série formé d'une source de tension (U') et d'une résistance de limitation (R) étant relié à la première et à la seconde borne de détecteur (1, 3).

7. Utilisation d'un dispositif selon l'une des revendications 1 à 5, caractérisée en ce que le détecteur de température est utilisé comme convertisseur température/tension sensiblement linéaire, une source de courant étant reliée directement à la première et à la deuxième borne de détecteur (1, 3), et un courant constant (l' ') appliqué induisant entre les bornes de détecteur une tension de sortie (U' ') dépendante de la température.

8. Procédé de fabrication d'un dispositif selon la revendication 1, comportant les phases suivantes :
- recouvrement simultané d'une zone pour la pluralité de cellules de puissance (LZ1, LZ2 . . .) et d'une zone pour les deux cellules de détecteur (SZ1, SZ2) par au moins une couche d'oxyde (GOX, DOX) ;
- réalisation simultanée de cuves (P11, P12) faiblement dopées du premier type de conductivité pour la pluralité de cellules de puissance (LZ1, LZ2 . . .) de la structure à semi-conducteurs de puissance (LH) et de cuves (P13, P14) faiblement dopées du premier type de conductivité pour les deux cellules de détecteur (SZ1, SZ2), les deux cuves (P13, P14) faiblement dopées pour les cellules du détecteur (SZ1, SZ2) étant si proches l'une de l'autre qu'elles se fondent l'une dans l'autre au moment de la réalisation ;
- réalisation simultanée de cuves (N31, N32) fortement dopées du second type de conductivité pour la pluralité de cellules de puissance de la structure à semi-conducteurs de puissance et de cuves (N33, N34) fortement dopées du second type de conductivité pour les deux cellules de détecteur, les deux cuves (N33, N34) fortement dopées pour les cellules de détecteur se trouvant à l'intérieur des cuves faiblement dopées pour les cellules de détecteur et étant si proches l'une de l'autre qu'elles ne laissent subsister qu'une zone étroite faiblement dopée du premier type de conductivité ;
- réalisation simultanée d'une couche d'oxyde intermédiaire (ZOX) munie de trous de contact pour la pluralité de cellules de puissance et d'une couche d'oxyde intermédiaire (ZOX) munie de trous de contact pour les deux cellules de détecteur ;
- et mise en place simultanée de liaisons (AL2 . . . AL4) pour les cellules de détecteurs (SZ1, SZ2) et de liaisons (AL1) pour la pluralité de cellules de puissance (LZ1, LZ2 . . .),

9. Procédé selon la revendication 8, caractérisé en ce qu'au moins une électrode de grille (PS1 . . . PS3) de la structure à semi-conducteurs de puissance pour la pluralité de cellules de puissance, qui est séparée du corps à semi-conducteurs par au moins une couche d'oxyde (GOX, DOX), et au moins une électrode de grille (PS4 . . .PS6) du détecteur de température pour les deux cellules de détecteur, qui est séparée du corps à semi-conducteurs par au moins une couche d'oxyde (GOX, DOX), sont réalisées simultanément et en ce que les deux électrodes de grilles servent de masque pour créer à la fois, à ajustage automatique, les cuves (P11 . . . P14) faiblement dopées du premier type de conductivité et les cuves (N31 . . .N34) fortement dopées du second type de conductivité, les dimensions des cuves faiblement dopées étant augmentées par rapport aux dimensions des cuves fortement dopées par une étape de recuit effectuée après l'adjonction de dopants dans les cuves faiblement dopées.
